Europäisches Patentamt

European Patent Office

Office européen des brevets

(11) Publication number: **0 389 625**

**A1**

## EUROPEAN PATENT APPLICATION
### published in accordance with Art. 158(3) EPC

(21) Application number: 89902550.6

(22) Date of filing: 21.02.89

(86) International application number:
PCT/JP89/00172

(87) International publication number:
WO 89/07999 (08.09.89 89/21)

(51) Int. Cl.5 **B23K 1/00**

(30) Priority: 29.02.88 JP 46639/88
29.03.88 JP 75190/88
19.08.88 JP 206593/88

(43) Date of publication of application:
03.10.90 Bulletin 90/40

(84) Designated Contracting States:
DE FR GB IT SE

(71) Applicant: **KABUSHIKI KAISHA KOMATSU
SEISAKUSHO**
3-6, Akasaka 2-chome
Minato-ku Tokyo 107(JP)

(72) Inventor: **KURIYAMA, Kazuya Prod. Techn.
Inst. of K.K.K.S.**
1-1-1, Ueno3-chome Hirakata-shi
Osaka-fu 573 o(JP)
Inventor: **KATADA, Kanji Prod. Techn. Inst. of
K.K.K.S.**
1-1, Ueno 3-chome Hirakata-shi
Osaka-fu 573(JP)

(74) Representative: **Dr. Fuchs, Dr. Luderschmidt
Dipl.-Phys. Seids, Dr. Mehler Patentanwälte**
Abraham-Lincoln-Strasse 7
D-6200 Wiesbaden(DE)

(54) **PROCESS FOR RESISTANCE DIFFUSION JUNCTION.**

(57) A process for resistance diffusion junction, which can be accomplished in a short time using simple equipment without exerting thermal influences on base metals to be joined and in which a high junction strength is attained by sufficient diffusion of an insert material provided between the surfaces of the base metals to be joined. The process involves a step of providing an insert material between the junction surfaces of a set of base metals to be joined present in close proximity, a step of melting the insert material between the junction surfaces and expelling excess insert material to form a thin-film insert material liquid phase by resistance heat generated by applying voltage across electrodes provided on the other side of each base metal and an applied pressure, and a step of diffusing the insert material at the junction surfaces. In order to prevent generation of Joule heat from the electrodes, an electroconductive heat-insulating material is provided between at least one of the base metals and the corresponding electrode. In addition, displacement during junction of the base metals is measured to control the pressure and quantity of electricity supplied through the electrodes based on the measured displacement value.

# 第 1 図

(Fig. 1)

P

4a

1

3

2

4b

P

電源 POWER SUPPLY

5

SPECIFICATION

INSTANTANEOUS LIQUID PHASE DIFFUSION BONDING

METHOD BY RESISTANCE HEATING

TECHNICAL FIELD OF THE INVENTION

This invention relates to a method of bonding materials of the same kind or those of different kinds, and more particularly to an instantaneous liquid phase diffusion bonding method by resistance heating to obtain an excellent bonded condition utilizing the heat developed by electric resistance.

BACKGROUND TECHNIQUES OF THE INVENTION

As methods of bonding the surfaces of materials of the same kind or those of different kinds, brazing and liquid phase diffusion bonding methods have so far been used widely.

The brazing method is a process wherein a brazing material whose melting point is lower than that of the materials to be bonded is interposed between the opposite surfaces of the materials to be bonded, and local heat is developed in the interface zone of the materials so as to cause fusion and diffusion of the brazing material by the local heat thus bonding them. In this brazing method, since the chemical composition of the brazing material is much different from that of the parent materials to be bonded, a high pressure cannot be applied to the interface zone of the materials to be bonded so that the thickness of fusion layer of the brazing material cannot be reduced, and so the bonded areas cannot be homogenized with the parent materials in several hours. Further, since the parent materials to be bonded must be heated at a temperature of 600 to 900°C, the effect of the heat on the parent materials is substantially high.

Therefore, the bonded.layer is inferior in mechanical and physical properties and also in bonding strength to the parent materials.

Whilst, the diffusion bonding method is a process wherein, as disclosed in U.S. Patent No. 3,678,570, an insert material composed of an alloy produced by adding highly diffusive elements whose melting points are low to a parent material is interposed between the interfacial areas of materials to be bonded, and then it is heated and pressurized to cause a primitive metallic bond in the interfacial areas. In this diffusion bonding process, the smoothness and the cleanliness of the surfaces of the parent materials to be bonded are indispensable requirements to achieve a satisfactory bond. Moreover, since the materials to be bonded are heated and pressurized in vacuum or in an atmosphere of an inert gas kept at a temperature of 1000°C or over, the kinds of materials to be bonded are limited. Further, an extended period of time is required for bonding them.

As mentioned above, the conventional brazing and diffusion bonding processes have so far posed problems such as adverse effect of the heat on the parent materials to be bonded, resultant insufficient bonding strength and the need for complexed or difficult bonding operations. Further, the conventional processes have required a long period of time to perform bonding operation, which promotes the above-mentioned points at issue further.

## SUMMARY OF THE INVENTION

The present invention has been achieved to solve the problems associated with the conventional brazing and diffusion bonding processes in view of the above-mentioned situation.

A first object of the present invention is to provide an instantaneous liquid phase diffusion bonding method by resistance heating wherein bonding operation can be conducted by means of a simple equipment in a short time in such a way as to exert little influence of the heat on the parent materials to be bonded, an insert material having an excellent diffusibility is used to enhance the bonding accuracy, and the insert material is fused by electric resistance heating, while it is pressurized to discharge a surplus amount of insert material so that the insert material may be diffused sufficiently in a thin-film liquid phase on the surfaces of the parent materials to be bonded thereby achieving a strong bond therebetween at a low cost.

A second object of the present invention is to provide an instantaneous liquid phase diffusion bonding method by resistance heating wherein dissipation of the Joule heat developed in the areas of the materials to be bonded through electrodes can be prevented to enhance further the diffusion of the insert material on the surfaces of the parent materials to be bonded.

A third object of the present invention is to provide an instantaneous liquid phase diffusion bonding method by resistance heating wherein possible deformation of materials to be bonded due to bonding can be avoided.

A fourth object of the present invention is to provide an instantaneous liquid phase diffusion bonding method by resistance wherein the adverse effect caused by the growth of coarse metallic crystalline grains in the bonded areas due to the resistance heating can be eliminated.

To achieve the above-mentioned first object, according to a first aspect of the present invention, there is provided an instantaneous liquid phase diffusion bonding method by resistance heating, characterized in that it

- 4 -

comprises the steps of interposing an insert material between the adjacent surfaces of a pair of materials to be bonded on one side thereof, fusing the insert material located between the surfaces to be bonded by the heat developed by resistance heating, which occurs when electric current is caused to flow through the materials to be bonded through the intermediary of electrodes located on the other side of the materials, and also by a pressure applied thereto·through the electrodes at the time of bonding, while a surplus amount of insert material is discharged therefrom so as to allow a required amount of insert material to be kept in a thin-film liquid phase, and diffusing the insert material in liquid phase on the surfaces of the materials to be bonded.

To achieve the above-mentioned second object, according to a second aspect of the present invention, there is provided an instantaneous liquid phase diffusion bonding method by resistance heating, characterized in that an electrically-conductive thermal insulation material is interposed between at least one of the materials to be bonded as set forth in the first aspect and the electrode thereof thereby preventing dissipation of the Joule heat from the electrode.

To achieve the above-mentioned third object, according to a third aspect of the present invention, there is provided an instantaneous liquid phase diffusion bonding method by resistance heating, characterized in that it further comprises the steps of measuring the displacement of one of the materials to be bonded at the time of bonding as set forth in the first aspect, and controlling the electric current supply and the pressure application through the electrodes, the materials to be bonded to the insert material according to the measured value of displacement.

To achieve the above-mentioned fourth object, according to a fourth aspect of the present invention, there is provided an instantaneous liquid phase diffusion bonding method by resistance heating, characterized in that it further comprises the step of subjecting the bonded product to a heat treatment so as to control the growth of coarse metallic crystalline grains in the bonded areas of the product.

Further, according to the present invention, there is provided an instantaneous liquid phase diffusion bonding method by resistance heating, characterized in that the insert material described in the first aspect contains highly diffusive elements such as Si, B, P and Cr, etc..

Still further, according to the present invention, there is provided an instantaneous liquid phase diffusion bonding method by resistance heating, characterized in that the thermal insulation material discribed in the second aspect is made of at least one selected from among the group consisting of tungsten, silver-tungsten and silver-tungsten carbide.

Yet further, according to the present invention, there is provided an instantaneous liquid phase diffusion bonding method by resistance heating, characterized in that the heat treatment described in the fourth aspect is conducted by keeping the bonded product in an atmosphere of ammonia kept at a temperature of 500 to 620°C for one to eight hours.

The advantages of the present invention obtainable from the above-mentioned aspects are as follows.

(1) The method of the present invention provides a remarkably high bonding efficiency as compared to the prior art method since the time required for bonding materials per one time is 0.2 to 0.3 seconds.

(2) Since a high diffusibility is obtained over the whole surfaces to be bonded, it becomes possible to effect instantaneous liquid phase diffusion bonding of different materials, which are much different in specific resistance and thermal conductivity from each other, such as iron and copper, by resistance heating.

(3) Since the diffusion bonding method according to the present invention is conducted with a low heat input, less deformation of the materials to be bonded occurs during or after the bonding so that after-treatment can be omitted, and also even in case bonding of materials needs to be performed after they have been subjected to hardening and tempering, changes in hardness and structure of the materials to be bonded do not occur so that simplification of the bonding process can be achieved.

(4) Inexpensive Fe series materials can be used for the component parts for which expensive materials such as Ni and Co series materials have been used as padding materials.

(5) Composite materials having a variety of properties such as resistance to wear, high strength and thermal conductivity, etc. can be easily obtained. Stating more specifically, sliding members such as shoes for swash plate type reciprocating pumps can be produced at a high efficiency.

The above-mentioned and other objects, aspects and advantages of the present invention will become apparent to those skilled in the art by making reference to the following description and the accompanying drawings in which preferred embodiments incorporating the principles of the present invention are shown by way of example only.

### BRIEF DESCRIPTION OF THE DRAWINGS

Fig. 1 is an explanatory view of one embodiment of the present invention and shows schematically an apparatus for carrying out the embodiment;

Fig. 2 is a graph showing the effect obtained by operational conditions at the time of bonding using the embodiment shown in Fig. 1 on the strength of bonded areas;

Fig. 3 is a graph showing comparison between the effect obtained by one of the insert materials used in the method of the present invention and that obtained by a silver-alloy brazing material available in the market which is used as a prior art example;

Fig. 4 is an explanatory view of another embodiment of the present invention and shows schematically an apparatus for carrying out the embodiment;

Fig. 5 is a longitudinal sectional view of bonded areas when an electrically-conductive thermal insulation material is not interposed between one of the materials to be bonded and the electrode thereof;

Fig. 6 is a longitudinal sectional view of bonded areas when an electrically-conductive thermal insulation material is interposed between one of the materials to be bonded and the electrode thereof;

Fig. 7 is a graph showing the bonding strength of the bonded areas obtained by using the embodiment shown in Fig. 4;

Fig. 8 is a graph showing comparison between the heat conductive condition of a Cu material and that of a SS 41 material, both Cu and SS 41 materials being used as the members to be bonded;

Fig. 9 is an explanatory view of a further embodiment of the present invention and shows schematically an apparatus for carrying out the embodiment;

Fig. 10 is a graph showing the applied pressure, the supplied electric current and the displacement of the pressure applying electrode at each step of the embodiment shown in Fig. 9;

Fig. 11 is a microscopic photograph showing a metallic structure of materials to be bonded before bonding; and

Figs.12 to 15 are microscopic photographs showing the metallic structure of bonded areas of the materials to be bonded shown in Fig. 11 using the apparatus shown in Fig. 9; Fig. 12 showing the condition just after the bonding, Fig. 13 showing the condition after heat treatment, Fig. 14 showing the condition of bonded interfacial areas immediately after the bonding, and Fig. 15 showing the condition of the bonded interfacial areas after the heat treatment.

## DETAILED DESCRIPTION OF THE INVENTION

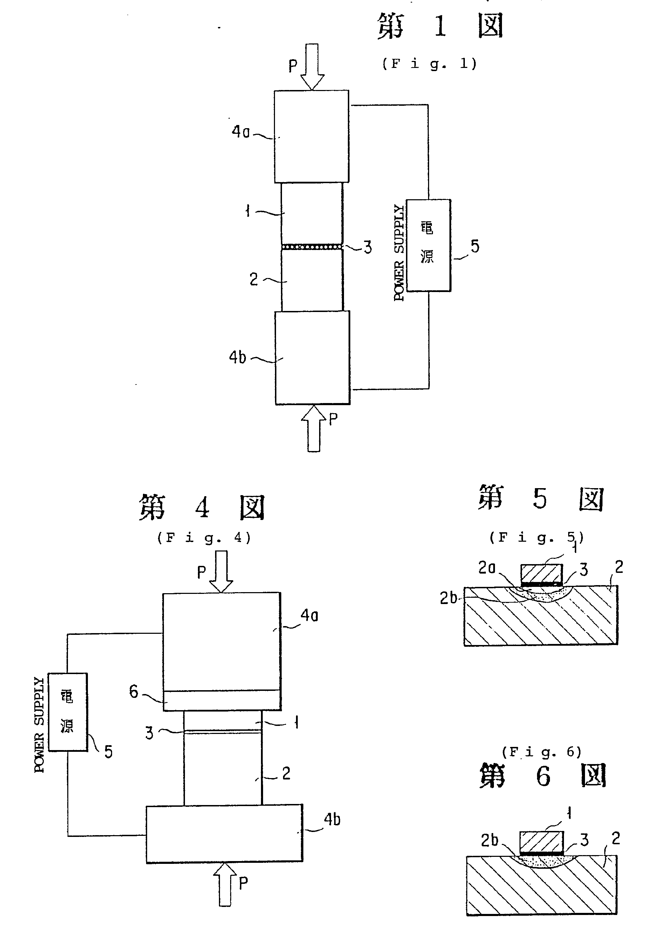

The first embodiment of the present invention will now be described with reference to Figs. 1 to 3.

As shown in Fig. 1, an insert material 3 is interposed between the opposite surfaces of materials 1 and 2 to be bonded. The materials 1 and 2 have electrodes 4a and 4b, respectively, located on the other side thereof for electric current supply and pressurization. The electrodes 4a and 4b are supplied with electric current from a power supply 5 for developing heat by resistance heating, and the materials 1 and 2 are urged towards each other by a pushing force P applied by a pressure applying device not shown.

As the insert material to be interposed between the materials 1 and 2 to be bonded, a Ni amorphous substance containing highly diffusive elements such as Si, B and Cr., etc. is used, and an example of the chemical composition thereof is shown in TABLE 1, such a Ni amorphous substance may contain P.

Bonding tests were conducted for different kinds of materials to be bonded as shown in TABLE 2 using the above-mentioned apparatus and insert material. Regarding the testing conditions, the electric current

- 11 -

used to develop the heat by electric resistance heating (electric current for bonding) was 12300 ampers and the applied pressure P was 450 kgf. Further, the film thickness of the insert material in the bonded area which was measured after the bonding test was 40 μm.

The result of the bonding tests is summarized in TABLE 2.

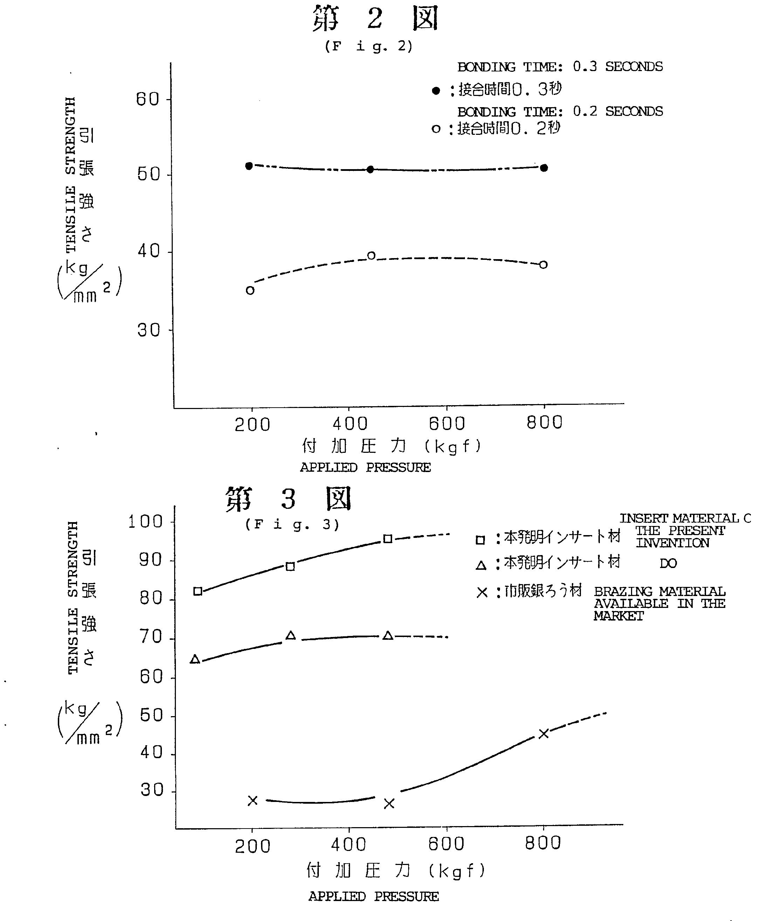

Further, the graph in Fig. 2 shows the effect obtained by operational conditions on the bonding strength of bonded areas, wherein the materials of the same kind (SS 41 according to JIS) are bonded using the insert material illustrated in TABLE 1 at a bonding electric current of 12300 amperes while the pressure applied to the materials is varied. This graph revealed that the bonding strength will increase in proportion to the bonding time, but the pressure applied to the materials to be bonded will not give much effect on the bonding strength.

Further, the graph in Fig. 3 shows the result of comparative bonding tests conducted using a silver-alloy brazing material, which is available in the market and used commonly for such a bonding is employed, and using the insert material of the present invention is used. As is apparent from the graphs, the material according to JIS SKD 11 which has been bonded (plotted with square marks in the graph in Fig. 3) and that according to JIS SUS 304 (plotted with triangular marks in the graph in Fig. 3) which has been bonded, using the insert material according to the present invention exhibit a much superior bonding strength to that of the material according to JIS SUS 304 which has been bonded using the silver-alloy brazing material available in the market (plotted with X marks in the graph in Fig. 3).

TABLE 1

| CONSTITUENT | Si | B | Cr | Fe | C | Ni |
|---|---|---|---|---|---|---|
| CONTENT<br><br>(% BY WEIGHT) | 4.0<br><br>∿5.0 | 2.75<br><br>∿3.50 | 6.0<br><br>∿8.0 | 2.5<br><br>∿3.5 | 0.06<br><br>OR<br>UNDER | REMAINDER |

TABLE 2

| MATERIALS TO BE BONDED | BONDING STRENGTH kg/MM² | |
|---|---|---|
| | BONDING TIME 0.2 SECONDS | BONDING TIME 0.25 SECONDS |
| 1. SS41<br><br>2. SKD 11 | 51.2 | 58.3 |
| 1. SS 41<br><br>2. SUS 304 | 53.9 | 53.9 |

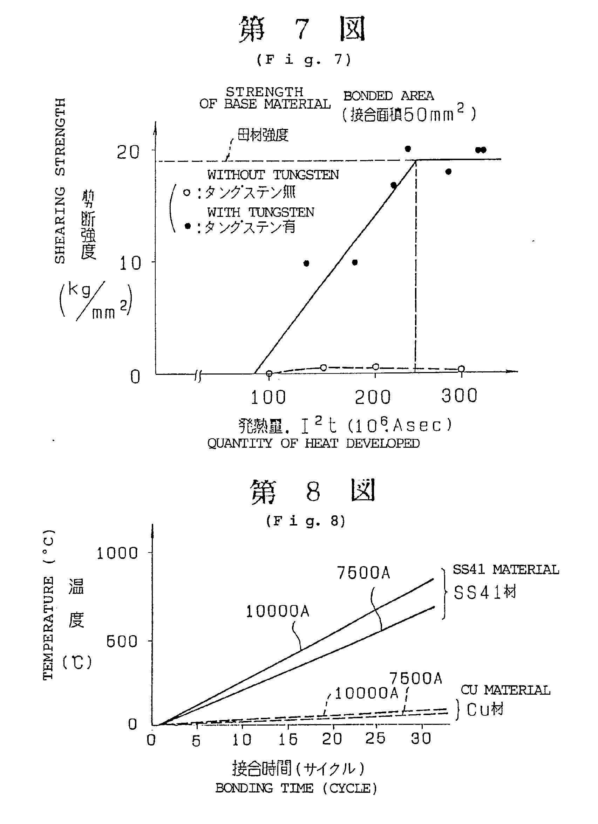

The second embodiment of the present invention will now be described with reference to Figs. 4 to 8.

The second embodiment relates to a method of effecting the diffusion of the insert material in the interface of the materials to be bonded in more advantageous manner in case at least one of the materials to be bonded is a substance having a high thermal conductivity such as copper or the like.

The apparatus used in the second embodiment shown in Fig. 4 is basically the same as that used in the first embodiment as shown in Fig. 1, and is characterized in that an electrically conductive thermal insulation material 6 is interposed between at least one of the electrodes, i.e., the electrode 4a and the material 1 to be bonded.

The electrodes used in the present invention are cooled by water so that the temperature thereof may be kept at, for example, below 200°C so as to improve the durability thereof. Thus, the Joule heat developed in the bonded areas by the electric current flowing through the resistance is dissipated through the materials 1 and 2 to be bonded and through the electrodes 4a and 4b to the surrounding atmosphere. For this reason, in case the materials 1 and 2 to be bonded are comprised of a substance having a high thermal conductivity, the quantity of heat to be dissipated will increase resulting in insufficient diffusion of the insert material on the

- 14 -

surfaces of the materials to be bonded.

In the second embodiment, to eliminate the above-mentioned difficulty, an electrically conductive thermal insulation material is interposed between at least one of the electrodes and one of the materials to be bonded.

In Fig. 4, reference numeral 1 denotes a Cu material, 2 a SS41 material, and 3 a Cu-series insert material having a high specific resistance and a high diffusibility.

The above-mentioned Cu material 1 and SS 41 material 2, with the Cu-series insert material 3 interposed therebetween and with a tungsten material 6 located adjacent to the Cu material 1, were supplied with electric current while they are pressurized towards each other by Cu electrodes 4a and 4b from both sides thereof.

In this embodiment, since the electrically conductive thermal insulation material 6 is located adjacent to the Cu material 1 having a high thermal conductivity, the dissipation of the Joule heat required to fuse the Cu-series insert material 3 to the electrode 4a was prevented, and as shown in Fig. 6, a uniform heat distribution over the whole bonded areas 2 b of the Cu material 1 and the SS 41 material 2 was obtained so that a satisfactory diffusion of the Cu-series insert material 3 over the bonded areas of the Cu material 1 and the SS 41 material 2 was obtained.

Further, in case the Cu material 1 is supplied with electric current while it is pressurized directly by the electrode 4a on the side of the Cu material 1 without interposition of the tungsten material 6, a portion 2a will not be subjected to the heat, as shown in Fig. 5. In this portion 2a, a sufficient diffusion of the Cu-series insert material 3 is not obtained thereby lowering the bonding strength.

As the electrically conductive thermal insulation material, in addition to tungsten, materials having a poor thermal conductivity, such as silver-tungsten, silver-tungsten carbide, etc. are suitable.

Fig. 7 shows measured values of the quantity of heat developed by the Cu-series insert material 3 and the shearing strength of the bonded areas obtained by applying the above-mentioned embodiment of the instantaneous liquid phase diffusing bonding method by resistance heating.

It will be seen from the graph in Fig. 7 that in case the tungsten material 6 is not used the bonding strength obtained is extremely low, whilst in case the tungsten material 6 is used the same bonding strength as that of the Cu material 1 is obtained when the quantity of heat developed by the Cu-series insert material 3 reaches about 240 x $10^6$ A·sec.

Fig. 8 shows, for reference purposes, a comparison between the thermal conductive characteristics of each of the Cu and SS 41 materials as the members to be bonded.

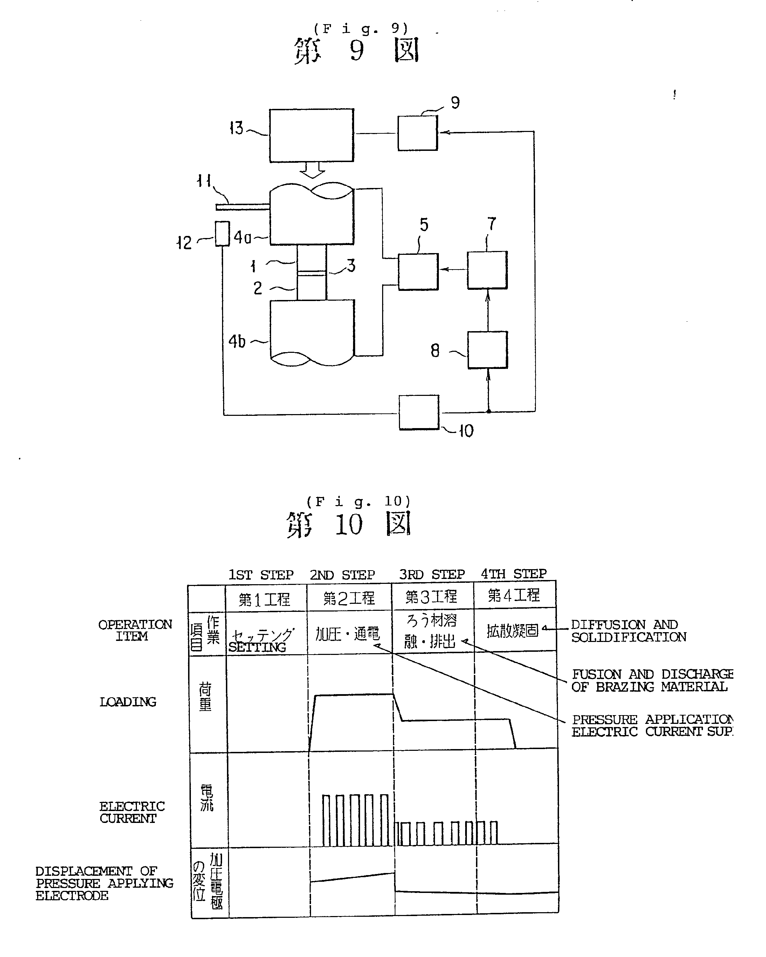

In the next place, the third embodiment of the present invention will be described with reference to Figs. 9 and 10.

In this third embodiment, a measure for preventing deformation of the materials to be bonded when the instantaneous liquid phase diffusion bonding process by resistance heating is applied.

Although the apparatus for carrying out the instantaneous liquid phase diffusion bonding method by resistance heating according to the present invention has been described hereinabove with reference to Figs. 1 to 4, since the electric current for heating and the pressure applied by the apparatus are considerably high, if such high electric current and pressure are applied continuously to the members to be bonded, then a deformation of them occurs. Therefore, in the third embodiment, the arrangement is made such that the displacement of the materials to be bonded is measured, and according to the measured value of displacement, the pressure applied through the electrodes and the electric current flow through them are controlled.

Fig. 9 is a block diagram showing the apparatus for carrying out the third embodiment of the instantaneous liquid phase diffusion, bonding method by resistance heating according to the present invention. In Fig. 9, materials to be bonded 1 and 2 are inserted between opposed electrodes 4a and 4b, and an insert material 3 comprised of a Ni-series amorphous substance is inserted between the materials 1 and 2 to be bonded. Reference numeral 13 denotes a pressure applying device, for example, of hydraulically operated type, 5 a power supply for supplying electric current between the electrodes 4a and 4b, 7 an electric current supply controlling device, and 8, 9 amplifiers adapted to amplify the signal transmitted by a control system 10.

Reference numeral 11 denotes a reference plate attached to the electrode 4a, and 12 a displacement meter for measuring the displacement of the reference plate 11.

The operation of the apparatus will now be described below.

The pressure applying device 13 is actuated by a pressure setting signal, which is preset by the control system 10, to apply a pressure on the electrode 4a so as to pressurize the Ni-series amorphous insert material inserted between the materials 1 and 2 to be bonded. Next, the power supply 5 is actuated by an electric current setting signal, which is preset by the control system 10, so as to supply electric current through the electrodes 4a and 4b, and then through the materials 1 and 2 to be bonded, and the Ni-series amorphous inset material 3 so as to fuse the insert material by the heat developed by resistance heating, and discharge the fused insert material 3 from between the materials 1 and 2 thereby increasing the displacement of the electrode 4a with consequential increase in the displacement of the reference plate 11. Then, the displacement meter will measure the displacement of the reference plate 11 and transmit a signal to the control system 10. The control system 10 will detect a transition point where the displacement of the reference plate 11 increases sharply and transmit a pressure setting signal, which is preset thereby, to the amplifier 9, and also transmit an electric current setting signal, which is preset thereby, to the amplifier 8. The amplifier 9 will amplify the pressure setting signal and actuate the pressure applying device 13 by a preset pressure. Further, the amplifier 8 will amplify the electric current setting signal received thereby and transmit a signal to the electric current supply controlling device

- 19 -

7. The electric current supply controlling device 7 will transmit a command signal indicative of preset values of cycle and electric current to the power supply 5. Then, the power supply 5 will supply electric current through the electrodes 4a and 4b, and then through the materials 1 and 2 to be bonded.

Fig. 10 shows the applied pressure, the supplied electric current and the displacement of the pressure applying electrode at each step in case a pair of round bars, 12 mm in diameter and 100 mm in length, which is made of a material according to JIS S 43C are subjected to the instantaneous liquid phase diffusion bonding by resistance heating using the resistance bonding or welding device as shown in Fig. 9.

In the first step, a Ni-series amorphous insert material is interposed and set between the round bars. Then, in the second step, a pressure of 550 kg was applied to them, while electric current of 18500 amperes, 17 cycles per second, was supplied through them. During this period, the electrode was slightly lifted due to the thermal expansion of the round bars.

In the third step, the insert material was fused and discharged from between the round bars with the result that the downward displacement of the electrode increased suddenly. Whereupon, the magnitude of pressure was reduced to 100 kg, and electric current of 5,000 amperes, 30 cycles per second, was supplied through them.

In the fourth step, the same electric current as that used in the third step was supplied through them while they are pressurized by the same loading as that used in the third step, and then the electric current supply and the pressure application were ceased.

As a result of conducting the instantaneous liquid phase diffusion bonding by resistance heating under the above-mentioned conditions, the amount of deformation of the bonded materials was 0.5 mm, which corresponds to one-seventh of the deformation that occurs in the prior art method, while the strength of the bonded areas was equivalent to that obtained by the prior art method.

Although, in the above-mentioned third embodiment, a Ni-series amorphous substance was used as the insert material, it was proved by the subsequent experiment that a similar result can be obtained even when a B Ni-2 material is used as the insert material.

Next, an actual product such as a machine component which requires essentially to have excellent sliding surfaces like, for example, shoes of a swash plate type reciprocating pump produced by the instantaneous liquid

- 21 -

phase diffusion bonding method by resistance heating according to the present invention will be described hereinbelow as a fourth embodiment.

A base member was produced using a bar material according to JIS SCM 440H (chrome-molybdenum steel for machine structure use), and was electroplated with copper after it was subjected to tempering. Then, as a sliding member to be bonded to this base member, a material according to JIS P31C was selected and cut to a size corresponding to the sliding surface of the base member. The P 31C material is a copper rich copper-zinc alloy, whose chemical composition is as shown in TABLE 3.

TABLE 3

| CONSTITUENT | Cu | Al | Fe | Zn | Ni | Si | OTHERS |
|---|---|---|---|---|---|---|---|
| W % | 67.0 ∿ 58.7 | 3.0 ∿ 4.0 | 0.5 ∿ 1.3 | 26.0 ∿ 30.0 | 2.5 ∿ 3.5 | 0.5 ∿ 1.5 | Bal |

The sliding member 1 was bonded to the base member 2 using an apparatus for instantaneous liquid phase diffusion bonding by resistance heating, which is capable of effecting the pressure application and resistance heating and which is similar to that shown in Fig. 4, under the condition of an electric current density of 80 ∿ 120 A/mm², an electric current supplying time of 60 to 90 cycles (1 cycle means 1/60 seconds) and a pressure of 4 to 9 kg/m². As the insert material 3, a material containing elements having a high diffusibility such as Si, B, P, Cr, etc. was used.

At the time of this bonding, the concentricity of the base member with the sliding member part was checked and adjusted, and after the bonding, the presence of imperfection in the bonded areas was checked by a flaw detective examination, and then the imperfect boned area were eliminated. Thereafter, finishing work of both the base member and the sliding member part was made so that the sliding member part was given a configuration meeting the intended machine component.

P 31 C alloy has so far showed a difficulty in bonding in that when the thickness of copper to be deposited previously on the base member 2 exceeds 10 μm the shearing strength of the bonded interface on the sliding member becomes more than 15 kg/m². According to the method of the present invention, however, it becomes possible even for P 31 C alloy to exhibit a sufficient bonding strength as a sliding member. This bonding strength is nearly the same as that of the JIS PBC 2A alloy (copper-tin-series alloy) which exhibits excellent bonding properties to steel materials.

The finished sliding member part was kept in an

- 23 -

atmosphere of ammonia kept at a temperature of 570°C for 5.5 hours. As a result, the sliding member part was subjected to nitriding and a heat treatment so that the intended sliding member was obtained. The heat treatment for controlling the growth of coarse metallic crystalline grains should preferably be performed at a temperature of 500 to 620°C for one to 8 hours.

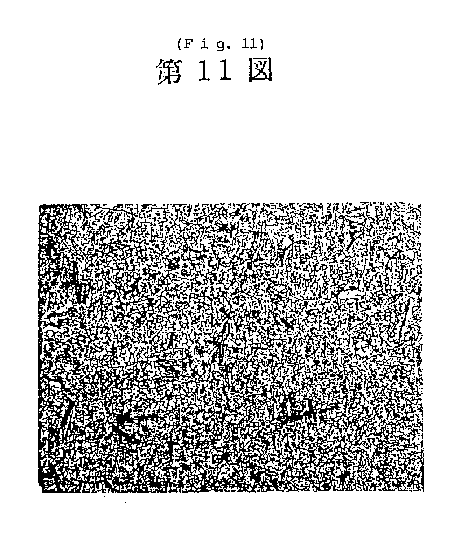

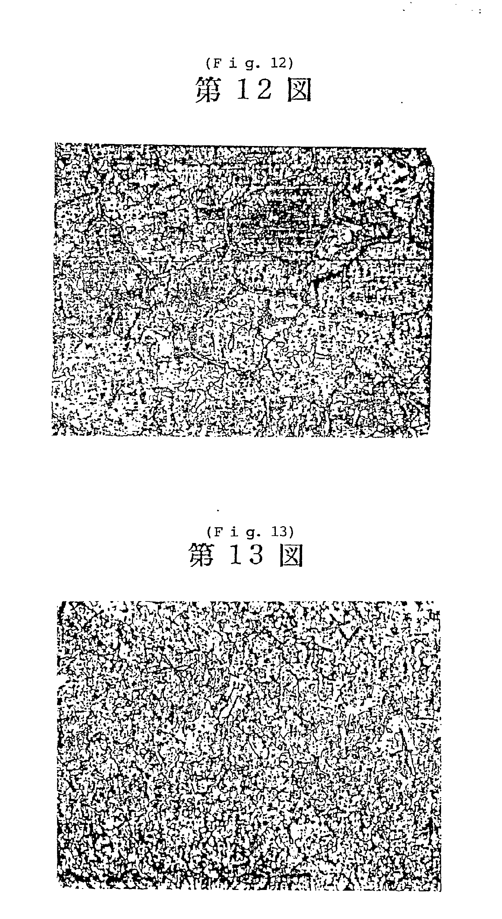

The sliding member obtained by the method of the present invention has excellent sliding properties. The sliding properties depend on the metallic structure. Figs. 11 to 13 show transition in the metallic structure of a P 31 C material which can exhibit an excellent bonding effect when the method of the present invention is applied. Fig. 11 shows the condition of the P 31 C material before bonding (i.e. when it is kept as cast), Fig. 12 shows the condition of the material just after it has been bonded to the base member, and Fig. 13 shows the state of the material after it has been subjected to the heat treatment. Before the bonding, alpha and beta phases had uniform and fine grains. However, immediately after the bonding, coarse crystalline grains grew in the metallic structure. When the material was subjected to the heat treatment, the structure thereof became nearly the same as that thereof before the bonding. It is obvious from this result that the sliding properties of the P 31 C material caused by the change in the metallic structure will decline just after the bonding, but it will be recovered by the heat treatment.

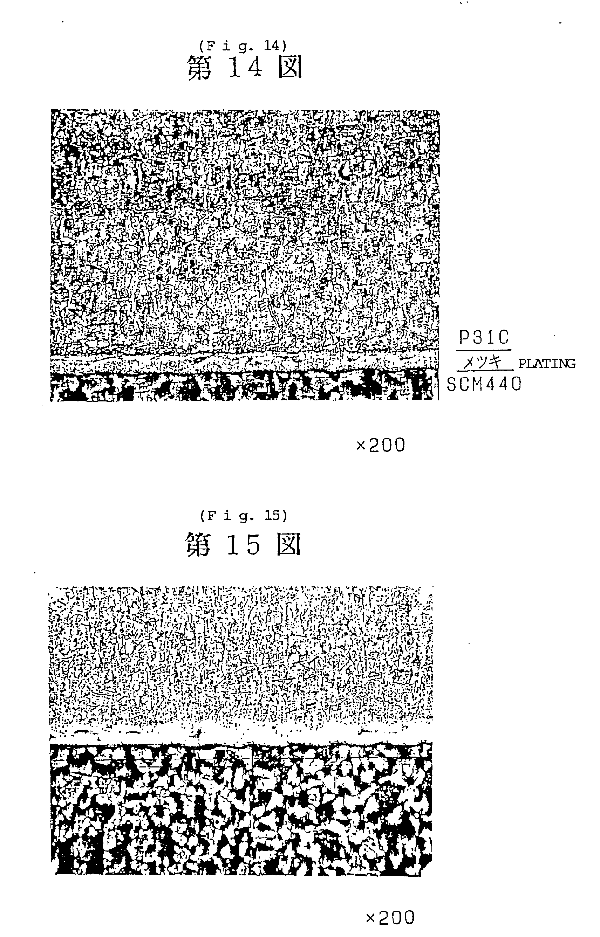

Figs. 14 and 15 show the structure in the boned interface areas. In Fig. 14 showing the condition immediately after the bonding, boundary zones between the base member, the plating layer and the sliding member can be seen clearly. From Fig. 15 showing the condition after the heat treatment, it was confirmed that a sufficient diffusion was made between the plating layer and the sliding member to ensure a satisfactory bond therebetween.

The foregoing description is merely illustrative of preferred embodiments of the present invention, but it is not intended to limit the scope of the present invention thereto many other changes and modifications of the invention will be made readily by those skilled in the art without departing from the scope or spirit of the present invention.

WHAT IS CLAIMED IS:

1.   An instantaneous liquid phase diffusion bonding method by resistance heating, characterized in that it comprises the steps of interposing an insert material between the adjacent surfaces of a pair of materials to be bonded on one side thereof, fusing said insert material located between the surfaces to be bonded by the heat developed by resistance heating, which occurs when electric current is caused to flow through the materials to be bonded through the intermediary of electrodes located on the other side of the materials, and also by a pressure applied thereto through the electrodes, while a surplus amount of insert material is discharged therefrom so as to allow a required amount of insert material to be kept in a thin-film liquid phase, and diffusing the insert material in liquid phase on the surfaces of the materials to be bonded.

2.   An instantaneous liquid phase diffusing bonding method by resistance heating as claimed in claim 1, characterized in that an electrically-conductive thermal insulation material is interposed between at least one of said pair of materials to be bonded and the electrode thereof thereby preventing dissipation of the Joule heat from the electrode.

3.   An instantaneous liquid phase diffusion bonding method by resistance heating as claimed in claim 1, characterized in that it further comprises the steps of measuring the displacement of one of the materials to be bonded at the time of bonding, and controlling the electric current supply and pressure application from the electrodes, the materials to be bonded to the insert material according to the measured value displacement.

4. An instantaneous liquid phase diffusion bonding method by resistance heating as claimed in claim 1, characterized in that it further comprises the step of subjecting the bonded product to a heat treatment so as to control the growth of coarse metallic crystalline grains in the bonded areas of the product.

5. An instantaneous liquid phase diffusion bonding method by resistance heating as claimed in claim 2, characterized in that it further comprises the steps of measuring the displacement of the materials to be bonded at the time of bonding, and controlling the electric current supply and the pressure application from the electrodes, the materials to be bonded to the insert material according to the measured value of displacement.

6. An instantaneous liquid phase diffusion bonding method by resistance heating as claimed in claim 2, characterized in that it further comprises the step of subjecting the bonded product to a heat treatment so as to control the growth of coarse metallic crystalline grains in the bonded areas of the product.

7. An instantaneous liquid phase diffusion bonding method by resistance heating as claimed in claim 3, characterized in that it further comprises the step of subjecting the bonded product to a heat treatment so as to control the growth of coarse metallic crystalline grains in the bonded areas· of the product.

8. An instantaneous liquid phase diffusion bonding method by resistance heating as claimed in claim 1, characterized in that said insert material contains highly diffusive elements such as Si, B, P, Cr, etc..

9. An instantaneous liquid phase diffusion bonding method by resistance heating as claimed in claim 1, characterized in that said insert material contains in the composition thereof 4.0 to 5.0 % by weight of Si, 2.75 to 3.50 % by weight of B, 6.0 to 8.0 % by weight of Cr, 2.5 to 3.5 % by weight of Fe, 0.06 % or under by weight of C, and the balance of Ni.

10. An instantaneous liquid phase diffusion bonding method by resistance heating as claimed in claim 2, characterized in that said thermal insulation material is made of at least one selected from among the group consisting of tungsten, silver-tungsten and silver-tungsten carbide.

- 29 -

11. An instantaneous liquid phase diffusion bonding method by resistance heating as claimed in claim 4, characterized in that said heat treatment is conducted by keeping the bonded product in an atmosphere of ammonia kept at a temperature of 500 to 620°C for one to eight hours.

第 1 図
(Fig. 1)

P

4a

1

3

2

4b

P

POWER SUPPLY 電源 5

第 4 図
(Fig. 4)

P

4a

6

3

1

2

4b

P

POWER SUPPLY 電源 5

第 5 図
(Fig. 5)

2a
2b

1
3
2

(Fig. 6)
第 6 図

2b
1
3
2

# 第 2 図
## (F i g. 2)

BONDING TIME: 0.3 SECONDS
● :接合時間0.3秒
BONDING TIME: 0.2 SECONDS
○ :接合時間0.2秒

TENSILE STRENGTH 引張強さ $\left(\dfrac{kg}{mm^2}\right)$

60
50
40
30

200  400  600  800

付 加 圧 力 （ｋｇｆ）
APPLIED PRESSURE

# 第 3 図
## (F i g. 3)

□ :本発明インサート材　INSERT MATERIAL C THE PRESENT INVENTION
△ :本発明インサート材　　DO
✕ :市販銀ろう材　BRAZING MATERIAL AVAILABLE IN THE MARKET

TENSILE STRENGTH 引張強さ $\left(\dfrac{kg}{mm^2}\right)$

100
90
80
70
60
50
40
30

200  400  600  800

付 加 圧 力 （ｋｇｆ）
APPLIED PRESSURE

# 第 7 図
## (Fig. 7)

STRENGTH OF BASE MATERIAL　BONDED AREA（接合面積５０mm²）

母材強度

SHEARING STRENGTH　剪断強度　$\left(\dfrac{kg}{mm^2}\right)$

WITHOUT TUNGSTEN
○：タングステン無
WITH TUNGSTEN
●：タングステン有

発熱量. $I^2 t$ (10⁶ Asec)
QUANTITY OF HEAT DEVELOPED

# 第 8 図
## (Fig. 8)

TEMPERATURE (°C)　温度　（℃）

7500A　SS41 MATERIAL　SS41材
10000A
10000A　7500A　CU MATERIAL　Cu材

接合時間（サイクル）
BONDING TIME (CYCLE)

(F i g. 9)

## 第 9 図

(F i g. 10)

## 第 10 図

| | | 1ST STEP 第1工程 | 2ND STEP 第2工程 | 3RD STEP 第3工程 | 4TH STEP 第4工程 | |
|---|---|---|---|---|---|---|
| OPERATION ITEM | 作業項目 | セッティング SETTING | 加圧・通電 | ろう材溶融・排出 | 拡散凝固 | ← DIFFUSION AND SOLIDIFICATION |
| LOADING | 荷重 | | | | | FUSION AND DISCHARGE OF BRAZING MATERIAL |
| ELECTRIC CURRENT | 電流 | | | | | PRESSURE APPLICATION ELECTRIC CURRENT SUP. |
| DISPLACEMENT OF PRESSURE APPLYING ELECTRODE | 加圧電極の変位 | | | | | |

EP 0 389 625 A1

(F i g. 11)

第 1 1 図

(Fig. 12)

第 1 2 図

(Fig. 13)

第 1 3 図

(F i g. 14)
## 第 1 4 図

P31C
メッキ PLATING
SCM440

×200

(F i g. 15)
## 第 1 5 図

×200

# INTERNATIONAL SEARCH REPORT

International Application No PCT/JP89/00172

**I. CLASSIFICATION OF SUBJECT MATTER** (if several classification symbols apply, indicate all) [6]

According to International Patent Classification (IPC) or to both National Classification and IPC

Int. Cl$^4$  B23K1/00

**II. FIELDS SEARCHED**

| Minimum Documentation Searched [7] | |
|---|---|
| Classification System | Classification Symbols |
| IPC | B23K1/00, 3/04, 11/24, 11/30, 20/00 |

| Documentation Searched other than Minimum Documentation<br>to the Extent that such Documents are Included in the Fields Searched [8] | |
|---|---|
| Jitsuyo Shinan Koho | 1926 - 1988 |
| Kokai Jitsuyo Shinan Koho | 1971 - 1988 |

**III. DOCUMENTS CONSIDERED TO BE RELEVANT [9]**

| Category * | Citation of Document, [11] with indication, where appropriate, of the relevant passages [12] | Relevant to Claim No. [13] |
|---|---|---|
| Y | JP, A, 56-062672 (Hitachi, Ltd.)<br>28 May 1981 (28. 05. 81)  (Family: none) | 1 |
| Y | JP, A, 49-102542 (Toshiba Tungaloy Co., Ltd.)<br>27 September 1974 (27. 09. 74)<br>(Family: none) | 1 |
| Y | JP, A, 48-070650 (Toshiba Corp.)<br>25 September 1973 (25. 09. 73)<br>(Family: none) | 1, 2 |
| Y | JP, A, 48-038851 (Hitachi, Ltd.)<br>7 June 1973 (07. 06. 73)  (Family: none) | 2 |
| Y | JP, B1, 43-022175 (Joseph Lucas Ltd.)<br>24 September 1968 (24. 09. 68)<br>(Family: none) | 3, 5 |
| Y | JP, A, 55-055075 (Honda Motor Co., Ltd.)<br>22 April 1980 (22. 04. 80)  (Family: none) | 4, 6, 7 |

* Special categories of cited documents: [10]

"A"  document defining the general state of the art which is not considered to be of particular relevance.

"E"  earlier document but published on or after the international filing date

"L"  document which may throw doubts on priority claim(s) or which is cited to establish the publication date of another citation or other special reason (as specified)

"O"  document referring to an oral disclosure, use, exhibition or other means

"P"  document published prior to the international filing date but later than the priority date claimed

"T"  later document published after the international filing date or priority date and not in conflict with the application but cited to understand the principle or theory underlying the invention

"X"  document of particular relevance; the claimed invention cannot be considered novel or cannot be considered to involve an inventive step.

"Y"  document of particular relevance; the claimed invention cannot be considered to involve an inventive step when the document is combined with one or more other such documents, such combination being obvious to a person skilled in the art

"&"  document member of the same patent family

**IV. CERTIFICATION**

| Date of the Actual Completion of the International Search | Date of Mailing of this International Search Report |
|---|---|
| April 10, 1989  (10. 04. 89 | April 24, 1989  (24. 04. 89) |

| International Searching Authority | Signature of Authorized Officer |
|---|---|
| Japanese Patent Office | |

Form PCT/ISA/210 (second sheet) (January 1985)

| FURTHER INFORMATION CONTINUED FROM THE SECOND SHEET | | |
|---|---|---|
| Y | JP, A, 57-022867 (Mitsubishi Heavy Industries, Ltd.)<br>5 February 1982 (05. 02. 82) (Family: none) | 8, 9 |
| Y | JP, A, 55-14110 (Honda Motor Co., Ltd.)<br>31 January 1980 (31. 01. 80) (Family: none) | 11 |

V.☐ OBSERVATIONS WHERE CERTAIN CLAIMS WERE FOUND UNSEARCHABLE [1]

This international search report has not been established in respect of certain claims under Article 17(2) (a) for the following reasons:

1.☐ Claim numbers ........., because they relate to subject matter not required to be searched by this Authority, namely:

2.☐ Claim numbers ..........., because they relate to parts of the international application that do not comply with the prescribed requirements to such an extent that no meaningful international search can be carried out, specifically:

3.☐ Claim numbers ........ ..., because they are dependent claims and are not drafted in accordance with the second and third sentences of PCT Rule 6.4(a).

VI.☐ OBSERVATIONS WHERE UNITY OF INVENTION IS LACKING [2]

This International Searching Authority found multiple inventions in this international application as follows:

1.☐ As all required additional search fees were timely paid by the applicant, this international search report covers all searchable claims of the international application.

2.☐ As only some of the required additional search fees were timely paid by the applicant, this international search report covers only those claims of the international application for which fees were paid, specifically claims:

3.☐ No required additional search fees were timely paid by the applicant. Consequently, this international search report is restricted to the invention first mentioned in the claims; it is covered by claim numbers:

4.☐ As all searchable claims could be searched without effort justifying an additional fee, the International Searching Authority did not invite payment of any additional fee.

Remark on Protest

☐ The additional search fees were accompanied by applicant's protest.

☐ No protest accompanied the payment of additional search fees.

Form PCT/ISA/210 (supplemental sheet (2)) (January 1985)